**Europäisches Patentamt**

**European Patent Office**

**Office européen des brevets**

(19)

(11) Numéro de publication : **0 350 977 B1**

(12)

# FASCICULE DE BREVET EUROPEEN

(45) Date de publication du fascicule du brevet :
**13.05.92 Bulletin 92/20**

(51) Int. Cl.$^5$ : **H05K 3/30, F16B 19/00**

(21) Numéro de dépôt : **89201466.3**

(22) Date de dépôt : **08.06.89**

(54) **Dispositif de fixation d'une pièce métallique sur une plaquette.**

(30) Priorité : **14.06.88 FR 8807908**

(43) Date de publication de la demande :
**17.01.90 Bulletin 90/03**

(45) Mention de la délivrance du brevet :
**13.05.92 Bulletin 92/20**

(84) Etats contractants désignés :
**BE DE FR GB**

(56) Documents cités :
**FR-A- 2 580 892**
**GB-A- 635 670**
**GB-A- 805 378**
**GB-A- 2 046 534**
**PATENT ABSTRACTS OF JAPAN, vol. 10, no. 285 (E-441)[2341], 27 septembre 1986, page 72 E 441; & JP-A-61 104-649**

(73) Titulaire : **PHILIPS ELECTRONIQUE GRAND PUBLIC**
**51, Rue Carnot**
**F-92150 Suresnes (FR)**
(84) **FR**

Titulaire : **N.V. Philips' Gloeilampenfabrieken**
**Groenewoudseweg 1**
**NL-5621 BA Eindhoven (NL)**
(84) **BE DE GB**

(72) Inventeur : **Guilleminot, Pierre**
**Société Civile S.P.I.D. 209, rue de L'Université**
**F-75007 Paris (FR)**

(74) Mandataire : **Charpail, François et al**
**Société Civile S.P.I.D. 156, Boulevard Haussmann**
**F-75008 Paris (FR)**

# Description

La présente invention concerne un dispositif de fixation d'une pièce sur une plaquette, ladite pièce comportant au moins une patte de fixation destinée à coopérer avec une fente aménagée dans ladite plaquette.

L'invention trouve une application particulièrement avantageuse dans le domaine de la fixation et de la soudure d'éléments métalliques, tels que boîtiers ou brides, devant être fixés et soudés sur des plaquettes de circuits imprimés.

On connaît de l'état de la technique un certain nombre de dispositifs de fixation d'une pièce sur une plaquette, du type de celui décrit dans le préambule. Le dispositif par pincement élastique (connu aussi sous le terme de "snap-in") exige au moins deux pattes de fixation terminées par une pliure devant passer au travers de la fente. Il en résulte un mauvais rapport patte de fixation/fente en ce sens que la section de la patte de fixation est beaucoup plus petite que l'ouverture de la fente, ce qui se traduit, d'une part, par une tenue médiocre de la pièce sur la plaquette, et, d'autre part, par un grand espace vide à combler lors de la soudure, à la vague par exemple, d'où les reprises de soudure qui entraînent une perte de temps au montage et un décollement des plages de cuivre des plaquettes de circuits imprimés dû à des fers trop chauds. Le dispositif de fixation par torsion de l'extrémité de la patte de fixation (dit aussi "twistage") exige, quant à lui, un appareillage spécial sur un poste de travail fixe dédié à cette opération supplémentaire coûteuse en temps. De plus, ce dernier dispositif présente une certaine agressivité à l'égard des plages de cuivre lorsque ladite plaquette est une plaquette de circuit imprimé. Enfin, le dispositif de fixation par pattes cisaillées offre simultanément tous les inconvénients d'une mauvaise tenue, d'un mauvais remplissage de la fente, dûs au faible rapport patte/fente, et d'une forte agressivité à l'encontre des circuits imprimés.

Aussi, le problème technique à résoudre par l'objet de la présente invention est de proposer un dispositif de fixation d'une pièce sur une plaquette, ladite pièce comportant au moins une patte de fixation destinée à coopérer avec une fente aménagée à travers ladite plaquette, dispositif qui, d'une part, assurerait une bonne tenue des pièces sur la plaquette, notamment lors du convoyage des plaquettes de circuits imprimés sur les chaînes d'insertion et lors du passage à la vague, et qui, d'autre part, permettrait d'obtenir des soudures de bonne qualité supprimant ainsi les reprises de soudure et les pertes de temps consécutives, tout ceci sans qu'un outillage particulier soit nécessaire.

La solution au problème technique posé consiste, selon la présente invention, en ce que ladite patte de fixation comporte une saillie élastique portant sur la plaquette à l'intérieur de la fente, et dont l'épaisseur est au moins égale à la largeur de ladite fente. Ainsi, la fixation est réalisée par accrochage positif de la patte dans l'épaisseur même de la plaquette, ce qui assure une excellente tenue qui peut être ajustée en jouant sur l'épaisseur de la saillie relativement à la largeur de la fente.

Cette qualité accrue de la fixation permet d'envisager d'utiliser le dispositif selon l'invention pour fixer avec une seule patte, des petits éléments dans des zones de la plaquette qui seraient déjà très encombrées.

On peut également constater que le rapport patte de fixation/fente est sensiblement amélioré du fait de la présence de la saillie. Il en découle des vides beaucoup moins grands à combler par la soudure, et, par conséquent, la qualité et la reproductibilité des soudures se trouvent accrues. Le rapport patte de fixation/fente peut encore être augmenté en diminuant la section de la fente, ce qui est réalisé lorsque ladite fente présente des angles arrondis sur le côté coopérant avec ladite saillie.

Enfin, dans le but d'éviter l'arrachement des plages conductrices lors de l'insertion de la patte de fixation dans la fente de la plaquette de circuit imprimé, il est prévu que l'extrémité débouchante de la patte de fixation présente des arrondis.

La description qui va suivre en regard des dessins annexés, donnés à titre d'exemples non limitatifs, fera bien comprendre en quoi consiste l'invention et comment elle peut être réalisée.

La figure 1 est une vue de face d'un dispositif de fixation selon l'invention.

La figure 2 est une vue de côté du dispositif de fixation de la figure 1.

La figure 3 est une vue de dessous du dispositif de fixation de la figure 1.

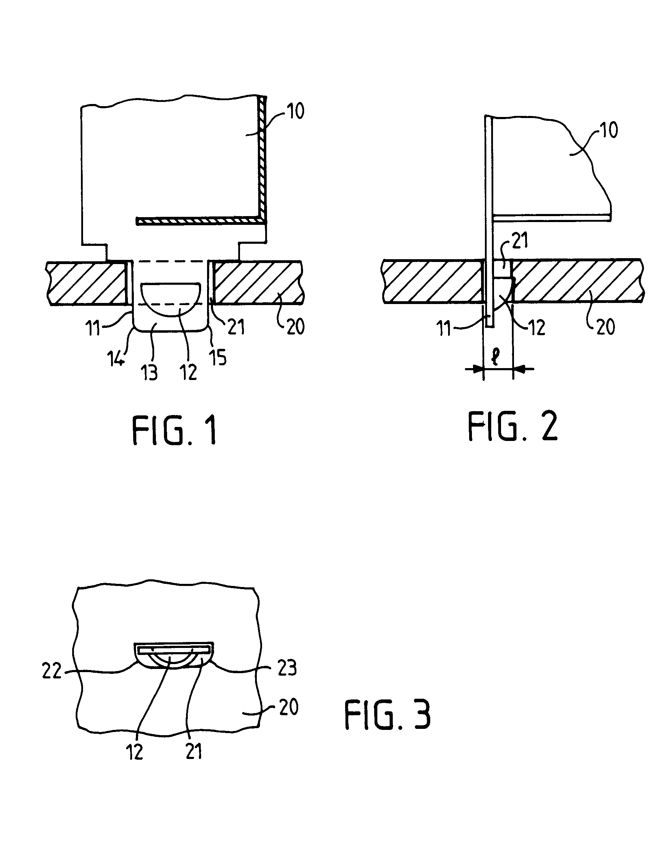

Les figures 1, 2 et 3 montrent, dans des vues de face, de côté et de dessous, un dispositif de fixation d'une pièce 10 sur une plaquette 20, qui peut être une plaquette de circuit imprimé, tandis que la pièce 10 représente, par exemple, un boîtier métallique enfermant un sous-ensemble électronique devant être fixé et soudé sur le circuit imprimé. La pièce 10 comporte une patte 11 de fixation destinée à coopérer avec une fente 21 aménagée à travers ladite plaquette 20. Comme on peut le voir aux figures 1, 2 et 3, ladite patte 11 de fixation comporte une saillie 12 portant sur la plaquette 20 à l'intérieur de la fente 21. L'épaisseur de la saillie 12 est au moins égale à la largeur 1 de la fente 21. Plus l'épaisseur de la saillie 12 sera grande et plus l'accrochage de la patte de fixation dans la fente 21 sera serré, en raison de l'élasticité de la saillie.

Dans l'exemple de réalisation montré aux figures 1, 2 et 3, ladite saillie 12 est un embouti ayant la forme d'un quart de sphère, réalisé sur la patte 11 de fixation.

Conformément à la figure 1, l'extrémité débouchante 13 de la patte 11 de fixation présente des arrondis 14, 15. Cette disposition avantageuse permet d'éviter le décollement, par arrachage, des pistes métalliques déposées sur la plaquette d'un circuit imprimé, que pourraient provoquer des angles vifs de l'extrémité débouchante 13.

Enfin, de façon à réduire encore l'espace vide entre la saillie 12 et le pourtour de la fente 21, ladite fente 21 présente des angles arrondis 22, 23 sur le côté coopérant avec la saillie 12. Ainsi, les soudures entre patte de fixation et les plages métalliques de la plaquette 20 situées à proximité de la fente 21 peuvent être réalisées de façon beaucoup plus sûre et reproductible.

## Revendications

1. Dispositif de fixation d'une pièce (10) sur une plaquette (20), ladite pièce (10) comportant au moins une patte (11) de fixation destinée à coopérer avec une fente (21) aménagée à travers ladite plaquette (20), caractérisé en ce que ladite patte (11) de fixation comporte une saillie élastique (12) portant sur la plaquette (20) à l'intérieur de la fente, et dont l'épaisseur est au moins égale à la largeur (1) de ladite fente (21).

2. Dispositif de fixation selon la revendication 1, caractérisé en ce que, ladite saillie (12) est un embouti réalisé sur la patte (11) de fixation.

3. Dispositif de fixation selon la revendication 2, caractérisé en ce que, ledit embouti a la forme d'un quart de sphère.

4. Dispositif de fixation selon l'une quelconque des revendications 1 à 3, caractérisé en ce que l'extrémité débouchante (13) de la patte (11) de fixation présente des arrondis (14,15).

5. Dispositif de fixation selon l'une quelconque des revendications 1 à 4, caractérisé en ce que ladite fente (21) présente des angles arrondis (22,23) sur le côté coopérant avec ladite saillie (12).

## Patentansprüche

1. Vorrichtung zum Befestigen eines Elementes (10) auf einer Platte (20), wobei dieses Element (10) mindestens einen Befestigungsfuß (11) aufweist zum Zusammenarbeiten mit einem durch die Platte (20) hindurchgehenden Schlitz (21), dadurch gekennzeichnet, daß dieser Befestigungsfuß (11) einen federnden Vorsprung (12) aufweist, der sich außerhalb des Schlitzes auf der Platte (20) abstützt und dessen Dicke der Breite (1) des genannten Schlitzes (21) mindestens entspricht.

2. Befestigungsvorrichtung nach Anspruch 1, dadurch gekennzeichnet, daß der genannte Vorsprung (12) eine am Befestigungsfuß (11) vorgesehene Ausbuchtung ist.

3. Befestigungsvorrichtung nach Anspruch 2, dadurch gekennzeichnet, daß die genannte Ausbuchtung die Form einer Viertelkugel hat.

4. Befestigungsvorrichtung nach einem der Ansprüche 1 bis 3, dadurch gekennzeichnet, daß das freie Ende (13) des Befestigungsfußes (11) Rundungen (14,15) aufweist.

5. Befestigungsvorrichtung nach einem der Ansprüche 1 bis 4, dadurch gekennzeichnet, daß der genannte Schlitz (21) auf der mit dem genannten Vorsprung (12) zusammenarbeitenden Seite gerundete Ecken (22, 23) aufweist

## Revendications

1. A device for mounting an element (10) on a board (20), the element (10) comprising at least one fixing lug (11) which is to engage in a through-hole (21) formed in the board (20), characterized in that said fixing lug (11) comprises an elastic projection (12) engaging the board (20) inside the hole, and having a thickness which is at least equal to the width (1) of the hole (21).

2. A mounting device as claimed in Claim 1, characterized in that the fixing lug (11) is formed with a projection (12).

3. A mounting device as claimed in Claim 2, characterized in that the projection has the shape of a quarter sphere.

4. A mounting device as claimed in any one of the Claims 1 up to an including 3, characterized in that the free end (13) of the fixing lug (11) has rounded portions (14, 15).

5. A mounting device as claimed in any one of the Claims 1 up to and including 4, characterized in that the hole (21) has rounded edges (22,23) at the side where it is engaged by the projection (12).

FIG. 1

FIG. 2

FIG. 3